# EUROPEAN PATENT APPLICATION

(11) **EP 4 741 840 A1**
(43) Date of publication of application: **13.05.2026**
(21) Application number: 24836366.5
(22) Date of filing: 05.07.2024
(51) Int. Cl.: G01R 19/165, G01R 27/26, G01R 23/165, G01R 31/28, G01Q 60/32

(54) **CONDUCTIVE ATOMIC FORCE MICROSCOPE**

(30) Priority: 05.07.2023 KR 20230087303; 04.07.2024 KR 20240088004
(71) Applicant: Park Systems Corp., Yeongtong-gu Suwon-si, Gyeonggi-do 16229 (KR)
(72) Inventor: JO, Ahjin, Seoul 06204 (KR); AHN, Byoung-Woon, Anyang-si Gyeonggi-do 14045 (KR); PARK, Sang-il, Seongnam-si Gyeonggi-do 13540 (KR)
(74) Representative: Müller Schupfner & Partner Patent- und Rechtsanwaltspartnerschaft mbB (Muc)
(86) International application number: PCT/KR2024/009536
(87) International publication number: WO 2025/009919

(57) **Abstract**

Disclosed is a conductive atomic force microscope capable of measuring the electric capacity of a sample by providing alternating current power to the sample. The conductive atomic force microscope includes: a voltage provision device for providing a voltage to a sample; a current detection device for detecting a current generated by the provided voltage; and a characteristic calculation device for calculating IV characteristics of the sample on the basis of the detected current, wherein the voltage provision device provides an alternating current (AC) voltage to the sample and the characteristic calculation device calculates the electric capacity of the sample on the basis of the detected current.

## Description

### Technical Field

The present disclosure relates to a conductive atomic force microscope, and more particularly, to a conductive atomic force microscope that scans the surface of a sample by means of a tip of a cantilever that contacts the surface of the sample.

### Background Art

An atomic force microscope (AFM) obtains surface information of a sample using a tip. The atomic force microscope includes a tip and a cantilever connected to the tip. The cantilever possesses a high degree of flexibility and bends due to the atomic repulsive force-specifically, attractive and repulsive forces-acting between the sharp tip suspended at its end and the sample surface, and by measuring the degree of this bending through changes in the reflection angle of laser light, surface information of the sample can be obtained.

The atomic force microscope can be divided into a contact mode and a non-contact mode. The atomic force between the tip and the sample changes from repulsive force to van der Waals attractive force as the distance between the two increases. The contact mode AFM uses repulsive force, and the non-contact mode AFM uses attractive force. The magnitude of the repulsive force used in the contact mode is very small, ranging from 1 to 10 nN, but the cantilever with the tip is also very sensitive, so it is bent by a small change in force. The angular displacement of the cantilever that occurs at this time also bends the angle of the laser beam reflected off the cantilever's upper surface, and by measuring the deflection angle of this laser beam using a PSPD (position sensitive photodiode), it is possible to recognize very small changes in surface elevation. Cantilevers are usually 100µm long, 10µm wide, and 1µm thick, and play a role in amplifying the microscopic interaction between the tip and the sample and transmitting it to the macroscopic world. The tip attached to the end of the cantilever is usually 10µm high and the diameter of the end of the tip is about 10nm. The contact mode AFM has the advantages of relatively easy operation and fast response speed.

The contact mode AFM includes a conductive atomic force microscope (C-AFM). The conductive atomic force microscope obtains surface information of a sample by applying a voltage to the sample and/or the tip and measuring the current flowing inside the sample due to the potential difference thereof.

A conventional conductive atomic force microscope measured the IV characteristics of the sample by providing a DC voltage to the sample and/or tip. Here, the IV characteristic includes the resistance between the tip and the sample, the threshold voltage, etc.

However, the conventional conductive atomic force microscope has a problem in that when the surface of a sample has an insulating structure, the current is not measured from the sample by a DC voltage method, so that the surface information of the sample cannot be obtained.

### Disclosure of Invention

### Technical Problem

An object of the present disclosure for solving the above-described problems is to provide a conductive atomic force microscope capable of measuring the electric capacity of a sample by providing AC power to the sample.

Another object of the present disclosure is to provide a conductive atomic force microscope capable of determining the electrical characteristics of a sample by providing a DC power and an AC power to the sample together.

### Solution to Problem

In order to achieve the above object, a conductive atomic force microscope according to an embodiment of the present disclosure is a conductive atomic force microscope (C-AFM, conductive-AFM) that scans the surface of the sample by measuring the current flowing in the sample through the tip of a cantilever, and the conductive atomic force microscope includes a voltage provision device for providing a voltage to the sample, a current detection device for detecting the current generated by the provided voltage, and a characteristic calculation device for calculating the IV characteristic of the sample based on the detected current, the voltage provision device provides an alternating current (AC) voltage to the sample, and the characteristic calculation device calculates the capacitance of the sample based on the detected current.

The voltage provision device provides a direct current (DC) voltage to the sample.

The voltage provision device provides the DC voltage to the sample and then provides the AC voltage.

The cantilever and the current detection device are connected to a first line through which a current generated by the provided voltage flows, and a current amplifier for amplifying the generated current is installed in the first line.

The current detection device measures the current amplified through the current amplifier.

The first line is branched into a second line and a third line, the second line outputs an output signal according to the DC voltage, and the third line outputs an output signal according to the AC voltage.

The characteristic calculation device calculates a resistance of the sample based on an output signal according to the DC voltage output through the second line, and calculates a capacitance of the sample based on an output signal according to the AC voltage output through the third line.

A low pass filter is installed in the second line.

A lock-in amplifier is installed in the third line, and the lock-in amplifier synchronizes a sample bias and a current of the tip to output an output signal according to the AC voltage.

### Advantageous Effects of Invention

According to the conductive atomic force microscope of the present disclosure, it is possible to measure the capacitance of the sample by providing AC power to the sample.

According to the conductive atomic force microscope of the present disclosure, DC power and AC power are provided to the sample together to determine the electrical characteristics of the sample.

### Brief Description of Drawings

FIG. 1 is a block diagram schematically illustrating each component of a conductive atomic force microscope according to the present disclosure.
FIG. 2 is a block diagram schematically illustrating each component of a conductive atomic force microscope measuring IV characteristics of a sample by providing a DC voltage.
FIG. 3 is a block diagram schematically illustrating each component of a conductive atomic force microscope for measuring capacitance of a sample by providing an AC voltage.
FIG. 4 is a diagram illustrating a state in which a conductive atomic force microscope according to the present disclosure measures a capacitance of a sample using an AC voltage.
FIGS. 5 and 6 are block diagrams illustrating each component of the conductive atomic force microscope of FIG. 1 in more detail.

### Best Mode for Carrying out the Invention

Hereinafter, some embodiments of the present disclosure will be described in detail with reference to exemplary drawings. In assigning reference numbers to the components of each drawing, it should be noted that the same components are made to have the same sign as much as possible, even if they are displayed on different drawings.

Further, in describing the embodiment of the present disclosure, a detailed description of known constructions or functions is omitted if it is determined that the detailed description of known constructions or functions hinders understanding of the embodiment of the present disclosure.

In addition, in describing the components of the embodiments of the present disclosure, terms such as first, second, A, B, (a), (b), and the like may be used. These terms are used only to distinguish a component from other components, and the nature, sequence, or order of the component is not limited by the terms.

In the present disclosure, the singular type also includes the plural type unless otherwise specified in the phrase. The "includes" and/or "including" used in the specification does not exclude the presence or addition of one or more other components other than the mentioned components.

Hereinafter, the present disclosure will be described in more detail with reference to the accompanying drawings.

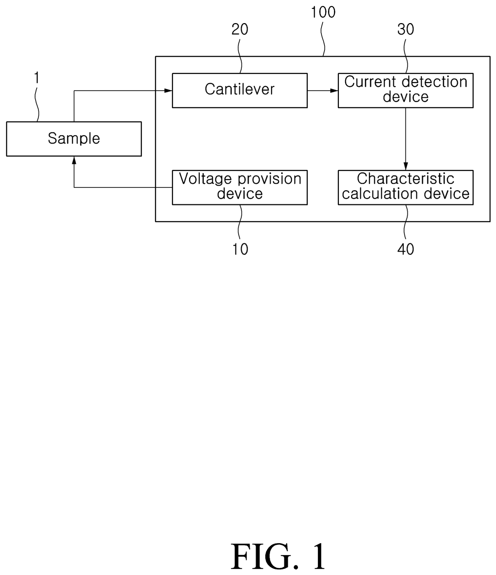

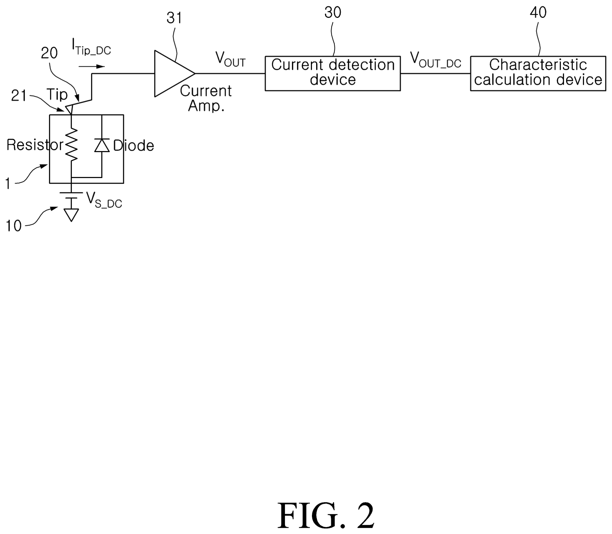

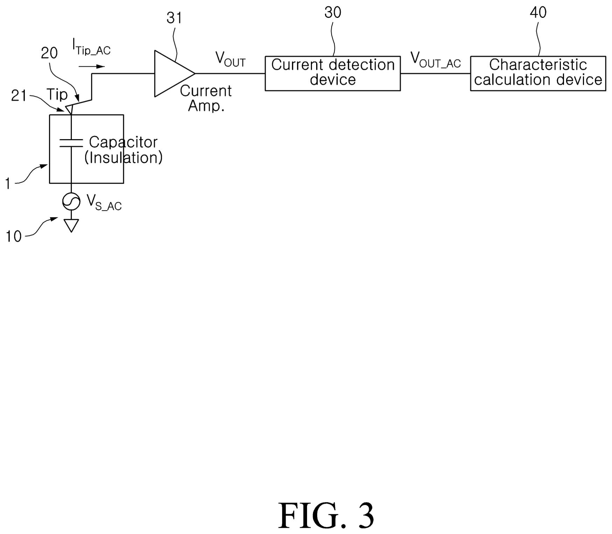

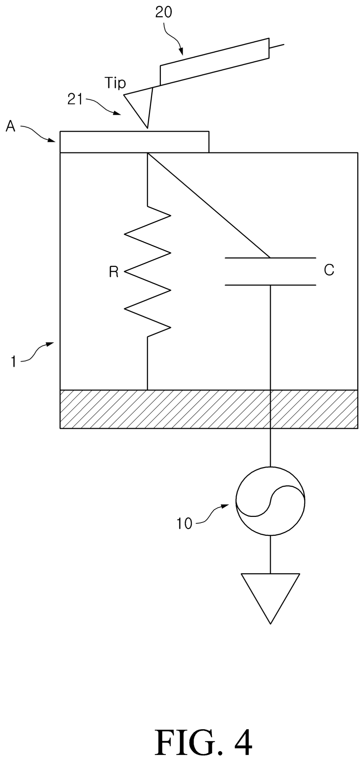

FIG. 1 is a block diagram schematically illustrating each component of a conductive atomic force microscope 100 according to the present disclosure, and FIG. 2 is a block diagram schematically illustrating each component of a conductive atomic force microscope 100 measuring IV characteristics of a sample 1 by providing a DC voltage. And, FIG. 3 is a block diagram schematically illustrating each component of a conductive atomic force microscope 100 for measuring the capacitance of a sample 1 by providing an AC voltage, and FIG. 4 is a diagram illustrating a state in which the conductive atomic force microscope 100 according to the present disclosure measures the capacitance of the sample 1 using the AC voltage.

A conductive atomic force microscope 100 (C-AFM, conductive-AFM) according to the present disclosure scans the surface of a sample 1 by measuring the current flowing in the sample 1 through a tip 21 of a cantilever 20.

The conductive atomic force microscope 100 according to the present disclosure includes a voltage provision device 10, a cantilever 20, a current detection device 30, and a characteristic calculation device 40, referring to FIGS. 1 to 3.

The voltage provision device 10 provides a voltage to the tip 21 or the sample 1. As the voltage provision device 10 provides a voltage to the tip 21 or the sample 1, a potential difference is generated between the sample 1 and the tip 21, and a current flows in the sample 1 due to the potential difference.

The current detection device 30 detects and measures the current generated by the provided voltage. The current detection device 30 detects and measures the current flowing inside the sample 1 according to the potential difference caused by the voltage provided by the voltage provision device 10.

The current flowing inside the sample 1 flows along the tip 21 in contact with the sample 1 and the cantilever 20 connected to the tip 21. The current detection device 30 detects and measures the current flowing along the tip 21 and the cantilever 20.

A current amplifier 31 is installed between the cantilever 20 and the current detection device 30. The current amplifier 31 amplifies a microscopic current signal at the level of pA to µA flowing through the sample 1, the cantilever 20 and the like.

The characteristic calculation device 40 calculates and derives the IV characteristic of the sample 1 based on the current detected by the current detection device 30. The IV characteristics of the sample 1 include the resistance of the sample 1 and the tip 21, a threshold voltage, a DC sample bias, a current flowing through the sample 1 and the tip 21 and the like.

Referring to FIG. 2, the voltage provision device 10 may provide a DC voltage to the tip 21 or the sample 1. When the voltage provision device 10 provides a DC voltage to the tip 21 or the sample 1, a current flows through the sample 1 and the tip 21 due to a potential difference according to the DC voltage, and a current detection device 30 detects and measures the current. The characteristic calculation device 40 calculates and derives the IV characteristic of the sample 1 based on the detected and measured current.

Referring to FIG. 3, the voltage provision device 10 may provide an AC voltage to the tip 21 or the sample 1. When the voltage provision device 10 provides an alternating voltage to the tip 21 or the sample 1, a current flows through the sample 1 and the tip 21 due to a potential difference according to the alternating voltage, and a current detection device 30 detects and measures the current. The characteristic calculation device 40 calculates the capacitance of the sample 1 based on the detected current and AC power information.

The characteristic calculation device 40 calculates the capacitance of the sample 1 based on the frequency and voltage of the AC voltage and the detected current.

The characteristic calculation device 40 provides, for example, an AC voltage of f(Hz) and V(V) to the sample 1 so that when a current of I(A) flows through the sample 1, the capacitance C(µF) of the sample 1 can be calculated as follows.

Capacitive reactance of a sample 1: Xc = V/I = 1/(2* π *f*C)

Accordingly, the capacitance C= I/(2* π *f *V) of the sample 1 is obtained. Here, 10⁶ may be multiplied to use the capacitance C in µF units.

The voltage provision device 10 provides a DC voltage and an AC voltage to the tip 21 or the sample 1 respectively or together. The voltage provision device 10 may provide a DC voltage to the tip 21 or the sample 1 for a certain period of time, and then provide an AC voltage for a certain period of time again.

When a DC voltage is applied to the tip 21 or the sample 1 while an insulating layer A (see, FIG. 4) is formed on the surface of the sample 1, a problem occurs in which it becomes difficult to measure the current flowing through the sample 1 due to the insulating layer.

The voltage provision device 10 provides an AC voltage after providing a DC voltage to the tip 21 or the sample 1, and as illustrated in FIG. 4, when it is difficult to calculate the IV characteristic by the DC voltage as the insulating layer A is formed on the surface of the sample 1, the characteristic calculation device 40 calculates the capacitance of the sample 1 based on the information of the AC voltage and the detected current.

In the conductive atomic force microscope 100 according to the present disclosure, by providing a DC voltage and an AC voltage to the tip 21 or the sample 1, it is possible to distinguish whether the electrical characteristics of the sample 1 are resistance or capacitance.

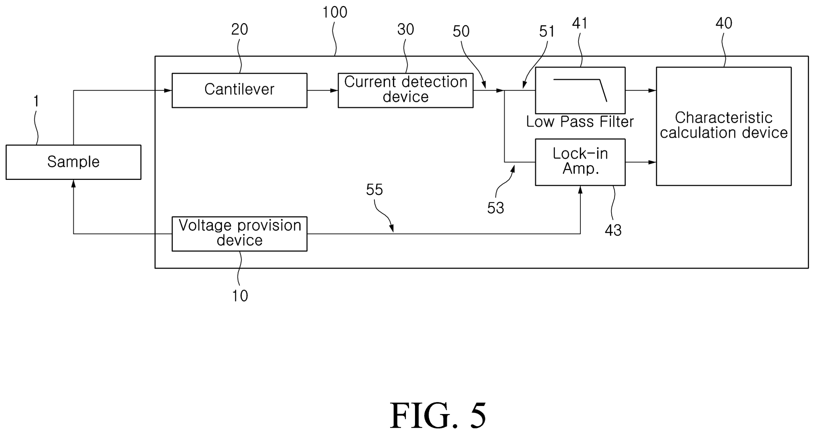

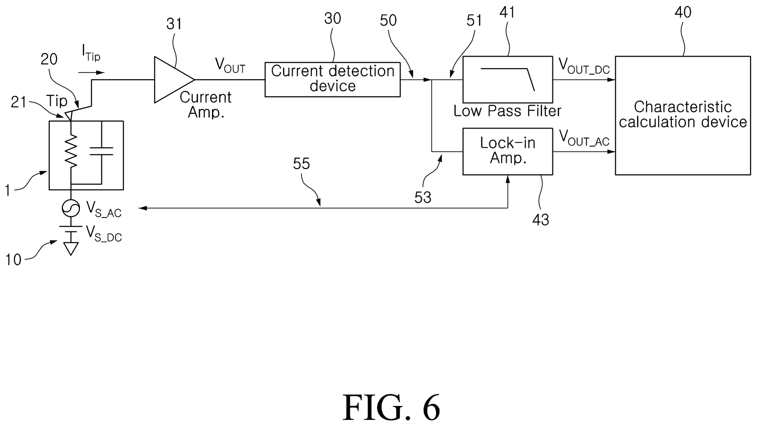

FIGS. 5 and 6 are block diagrams illustrating each component of the conductive atomic force microscope 100 of FIG. 1 in more detail.

The cantilever 20 and the current detection device 30 are connected to the first line 50 with reference to FIGS. 5 and 6. A current generated by a voltage provided by the voltage provision device 10 flows through the first line 50. Between the cantilever 20 and the current detection device 30, a current amplifier 31 is installed to amplify the current flowing as described above. The current amplifying apparatus 31 amplifies a microscopic current signal at a pA to µA level. The current detection device 30 detects and measures a current signal amplified by the current amplifier 31.

The first line 50 is branched to the second line 51 and the third line 53 after the current detection device 30. The second line 51 outputs an output signal according to a DC voltage, that is, a DC component. The third line 53 outputs an output signal according to an AC voltage, that is, an AC component.

The characteristic calculation unit 40 calculates IV characteristics such as resistance of the sample 1 based on an output signal (DC component) according to a DC voltage output through the second line 51. The characteristic calculation device 40 calculates the capacitance of the sample 1 based on the output signal (AC component) according to the AC voltage output through the third line 53.

A low pass filter 41 is installed in the second line 51. The low pass filter 41 blocks a high-band frequency and provides only a DC component of a low-band frequency to the characteristic calculation device 40 to eliminate noise from a high-band frequency.

A lock-in amplifier 43 is installed in the third line 53. The lock-in amplifier 43 receives a sample bias through the fourth line 55 and synchronizes the received sample bias and the current of the tip 21 to output an output signal (AC component) according to the AC voltage.

The scope of protection of the present disclosure is not limited to the description and expression of the embodiments explicitly described above. Additionally, it is reiterated that the scope of protection of the present disclosure may not be limited by obvious changes or substitutions in the technical field to which the present disclosure pertains.

## Claims

1. A conductive atomic force microscope (C-AFM, conductive-AFM) that scans the surface of a sample by measuring the current flowing in the sample through the tip of a cantilever, comprising:
a voltage provision device for providing a voltage to the sample;
a current detection device for detecting the current generated by the provided voltage; and
a characteristic calculation device for calculating IV characteristic of the sample based on the detected current,
the voltage provision device provides an alternating current (AC) voltage to the sample, and
the characteristic calculation device calculates the capacitance of the sample based on the detected current.

2. The conductive atomic force microscope of claim 1,
the voltage provision device provides the direct current (DC) voltage to the sample.

3. The conductive atomic force microscope of claim 2,
the voltage provision device provides the DC voltage to the sample and then provides the AC voltage.

4. The conductive atomic force microscope of claim 2,
the cantilever and the current detection device are connected to a first line through which a current generated by the provided voltage flows, and
a current amplifier for amplifying the generated current is installed in the first line.

5. The conductive atomic force microscope of claim 4,
the current detection device measures the current amplified through the current amplifier.

6. The conductive atomic force microscope of claim 5,
the first line is branched into a second line and a third line,
the second line outputs an output signal according to the DC voltage, and
the third line outputs an output signal according to the AC voltage.

7. The conductive atomic force microscope of claim 6,
the characteristic calculation device calculates a resistance of the sample based on the output signal according to the DC voltage output through the second line, and calculates a capacitance of the sample based on the output signal according to the AC voltage output through the third line.

8. The conductive atomic force microscope of claim 7,
a low pass filter is installed in the second line.

9. The conductive atomic force microscope of claim 7,
a lock-in amplifier is installed in the third line, and
the lock-in amplifier synchronizes a sample bias and a current of the tip to output an output signal according to the AC voltage.
